# EUROPÄISCHE PATENTSCHRIFT

(11) **EP 1 338 090 B1**
(45) Veröffentlichungstag und Bekanntmachung des Hinweises auf die Patenterteilung: **20.02.2008**
(21) Anmeldenummer: 01996923.7
(22) Anmeldetag: 15.11.2001
(51) Int. Cl.: H03K 17/30, G01R 19/165

(54) **EIN STROMFÜHLENDER SCHALTERSTROMKREIS**
A CURRENT-SENSING SWITCHING CIRCUIT
CIRCUIT ELECTRIQUE DE COMMUTATION A DETECTION DE COURANT

(30) Priorität: 16.11.2000 DE 10056878
(43) Veröffentlichungstag der Anmeldung: 27.08.2003
(73) Patentinhaber: ROBERT BOSCH GMBH, 70442 Stuttgart (DE)
(72) Erfinder: BAZIL, Rodricks, Roweville (AU)
(86) Internationale Anmeldenummer: PCT/DE2001/004284
(87) Internationale Veröffentlichungsnummer: WO 2002/041491

(56) Entgegenhaltungen:
- EP-A- 0 317 007
- EP-A- 1 096 262
- WO-A-00/14889
- US-A- 6 100 814
- "AUTO POWER TAP WITH NEAT THRESHOLD" IBM TECHNICAL DISCLOSURE BULLETIN, IBM CORP. NEW YORK, US, Bd. 37, Nr. 6B, 1. Juni 1994 (1994-06-01), Seiten 615-616, XP000456118 ISSN: 0018-8689
- RUFFELL J: "SLAVE MAINS ON-OFF CONTROL" ELEKTOR ELECTRONICS, ELEKTOR PUBLISHERS LTD. CANTERBURY, GB, Bd. 16, Nr. 180, 1. Juli 1990 (1990-07-01), Seiten 532-533, XP000132722 ISSN: 0268-4519
- RUFFELL J: "SLAVE MAINS ON-OFF CONTROL" ELEKTOR ELECTRONICS, ELEKTOR PUBLISHERS LTD. CANTERBURY, GB, Bd. 17, Nr. 195, 1. Dezember 1991 (1991-12-01), Seiten 60-61, XP000284898 ISSN: 0268-4519
- PATENT ABSTRACTS OF JAPAN vol. 1999, no. 11, 30. September 1999 (1999-09-30) & JP 11 160368 A (TDK CORP), 18. Juni 1999 (1999-06-18)
- PATENT ABSTRACTS OF JAPAN vol. 013, no. 520 (P-963), 21. November 1989 (1989-11-21) & JP 01 212364 A (MATSUSHITA ELECTRIC IND CO LTD), 25. August 1989 (1989-08-25)

## Beschreibung

Die vorliegende Erfindung bezieht sich auf elektronische Schaltungen, und insbesondere auf einen elektronischen Schalterstromkreis zum Schalten der Spannung an einem Ausgabeanschluß in Reaktion auf den Strom, der von einem zweiten Ausgabeanschluß abgenommen wird.

Viele elektronische Systeme sind für Dauerbetrieb konzipiert, so daß sie immer für Eingangssignale reaktionsfähig sind. Um Energie zu sparen, haben diese Systeme oft einen Ruhe- oder Bereitschaftsmodus, wobei Leistung nur jenen Schaltungen zugeführt wird, die wesentlich für die Erkennung von Eingangssignalen sind und den ruhigen Systemschaltungen ermöglichen, schnell eingeschaltet zu werden. Eingangssignale werden normalerweise von einem elektronischen Schalterstromkreis erkannt, welcher diesen ruhigen Schaltungen Strom zuführt. Zum Beispiel sind kürzlich eingeführte schlüssellose Verriegelungssysteme für Automobile in der Lage, Kraftwagen in Reaktion auf von einem Sender eines elektronischen Schlüssels übermittelte Radiofrequenzsignale zu verriegeln oder zu entriegeln. Die Verriegelungsschaltung beinhaltet eine selbstabrufende Ultrahochfrequenz- (UHF)Empfängerschaltung und einen störungsarmen Verstärker (LNA). Weil das Verriegelungssystem immer auf UHF-Signale ansprechbar sein muß, ist es wichtig, den Leistungsverbrauch der Schaltungen gering zu halten, um zu verhindern, daß die Autobatterie erschöpft wird. Der selbstabrufende UHF Empfänger ist zwischen einem Ruhemodus und einem Betriebsmodus schaltbar. Es ist offensichtlich wünschenswert, das LNA in Tandem zu schalten, so daß es nur unter Strom gesetzt wird, wenn der UHF Empfänger unter Strom steht.

Derzeit bekannte Systeme haben dies durch Verwendung eines Spannungskomparators zur Überwachung der Ausgangsspannung der UHF-Empfängerschaltung erzielt. Wenn der UHF-Empfänger von dem Ruhezustand in den Betriebszustand umschaltet, erfaßt der Spannungskomparator die Veränderung in der Ausgangsspannung und führt dem LNA Strom zu. Das Problem mit diesem Verfahren ist, daß die Ausgangsspannung des UHF-Empfängers nicht gut geregelt ist. Infolgedessen kann das LNA irrtümlicherweise aufgrund elektrischen Rachens und Temperaturschwankungen unter Strom gesetzt werden. Des weiteren ist die Empfindlichkeit des Systems vermindert, wenn das LNA nicht in Tandem mit dem UHF Empfänger angeschaltet ist.

Aus der WO 00/14889 A ist eine elektronische Schaltungsanordnung mit einem Empfangsteil, welches ein von außen einfallendes, physikalisches Signal erfasst und als Reaktion hierauf einen elektrischen Signalstrom liefert, bekannt. Die Schaltungsanordnung weist einen dem Empfangsteil zugeordneten Steuer- und Auswerteteil auf, welcher mit dem elektrischen Signalstrom beaufschlagt ist und an dessen Signalausgang ein elektrisches Auswertesignal abgreifbar ist. Weiterhin ist die Schaltungsanordnung in einem ersten, bei eingeschalteter Versorgungsspannung arbeitenden Betriebszustand und in einem zweiten, bei abgeschalteter Versorgungsspannung ohne Leistungsaufnahme ruhenden Ruhezustand betreibbar, wobei parallel zu der aus Empfangsteil und Steuer- und Auswerteteil bestehenden Serienschaltung ein Ruhestromdetektor geschaltet ist, der im Ruhezustand der Schaltungsanordnung den vom Empfangsteil gelieferten Signalstrom erfasst und als Reaktion hierauf ein Einschalten der Schaltungsanordnung in den Betriebszustand steuert.

Es ist Ziel der vorliegenden Erfindung, eine zuverlässige Schaltung für die Zuführung von Strom in Reaktion auf Veränderungen eines elektrischen Signals oder wenigstens eine zweckmäßige Alternative bereitzustellen.

Die vorliegende Erfindung betifft einen stromfühlenden Schalterstromkreis mit einer ersten Anschlussklemme für die Stromzuführung für eine erste Einheit, wobei gestützt auf den Zustand einer zweiten Einheit, der an einer zweiten Anschlussklemme erkannt wird, die erste Anschlussklemme geschaltet wird, wobei der Zustand durch den Strom erkannt wird, der an der zweiten Anschlussklemme abgenommen wird. Erfindungsgemäß sind ein Schaterstromkreis zum Schalten der ersten Anschlussklemme und eine Stromspiegelanordnung mit spannungsteilenden Widerständen vorgesehen, um eine Spannung zu erzeugen, die proportional zu dem Strom an der zweiten Anschlussklemme ist, wobei die Spannung den Schalterstromkreis steuert.

Vorteilhafterweise ist die zweite Einheit ein Hochfrequenz-Empfänger mit einem Betriebsmodus (run mode) und einem Bereitschaftsmodus (sleep mode), der, wenn in Betrieb, mit dem zweiten Anschluß verbunden ist, wobei die erste Einheit ein LNA sein kann. Bevorzugterweise ist der abgenommene Strom unterhalb eines Schwellpegels während des Bereitschaftsmodus und oberhalb des Schwellpegels während des Betriebsmodus.

Bevorzugte Ausführungen der vorliegenden Erfindung sind nachfolgend in Bezug auf die beiliegenden Zeichnungen nur als Beispiel beschrieben, wobei
Figur 1 ein Blockschema einer bevorzugten Ausführung einer UHF EmpfängerSchaltung ist;
Figur 2 ein Schaltbild einer Stromspiegelschaltung ist;
Figur 3 ein Schaltbild einer bevorzugten Ausführung einer stromfühlenden Schaltung der UHF Empfängerschaltung ist;
Figur 4 ein Schaltbild einer sich in Betriebsmodus (run mode) befindlichen Schaltung eines stromfühlenden Schalterstromkreises und eines UHF Modulators ist; und
Figur 5 ein Schaltbild einer sich in Bereitschaftsmodus (sleep mode) befindlichen Schaltung eines stromfühlenden Schalterstromkreises und eines UHF Modulators ist.

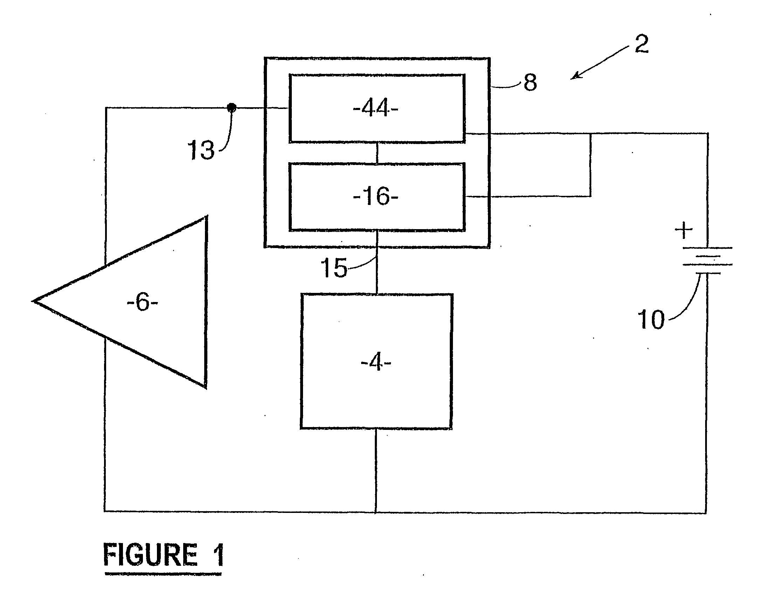

Eine Empfängerschaltung 2 eines Fahrzeugtür-Verriegelungssystems, wie in Figur 1 gezeigt, schließt einen Motorola Romeo-2 Empfänger Chip 4 zur Demodulation empfangener UHF-Signale und einen störungsarmen Verstärker (LNA) 6 zur Verstärkung der demodulierten Signale ein. Der Demodulator 4 hat zwei Arbeitsweisen (operating modes): einen Betriebsmodus (run mode), in welchem der Demodulator 4 einen Mindeststrom von 4 mA von der Stromzuführung 10 über eine Lastklemme 15 abnimmt, und einen Bereitschaftsmodus (sleep mode), in welchem der Demodulator 4 nur ≈ 270 µA abnimmt. Um Strom zu sparen, wird der LNA nur durch die Anschlußklemme 13 unter Strom gesetzt, wenn der Demodulator 4 in Betriebsmodus ist. Ein stromfühlender Schalterstromkreis 8 erzielt dies durch Messen des Stroms, der von dem Demodulator 4 an der Lastklemme 15 abgenommen wird, und durch Zuführung einer Spannung, die nahe der Versorgungsspannung ist, wenn der Demodulator 4 in Betriebsmodus ist, und Zuführung einer Spannung, die nahe an Null ist, wenn der Demodulator 4 in Bereitschaftsmodus ist. Ein Tandemschalter gewährleistet daher, daß der Demodulator 4 und der LNA 6 in Tandem laufen und ruhen.

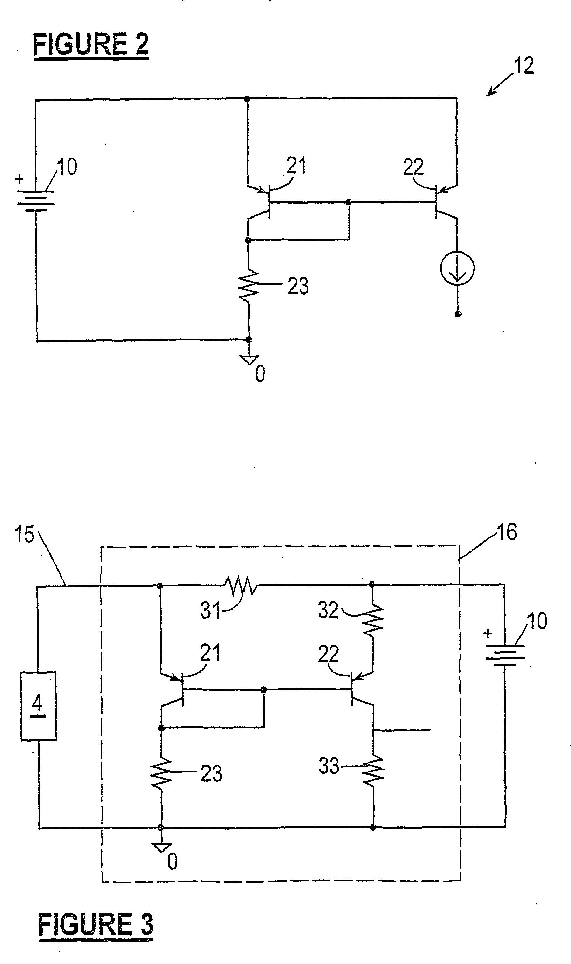

Der stromfühlende Schalterstromkreis 8 umfaßt eine stromfühlende Schaltung 16 und einen Vcc Schalterstromkreis 44. Die stromfühlende Schaltung 16 stützt sich auf eine Standard-Stromspiegelschaltung, normalerweise als eine konstante Stromquelle. Wie in Figur 2 gezeigt, umfaßt eine Standard-Stromspiegelschaltung 12 zwei nominell identische pnp-Transistoren 21 und 22 (Siemens BC8568), deren Emitter mit einer gemeinsamen Speisespannungsschiene 14 verbunden sind, und deren Basen direkt miteinander verbunden sind. Der Kollektor des ersten Transistors 21 ist mit der Basis kurzgeschlossen und durch einen Widerstand 23 geerdet. Der Kollektor des zweiten Transistors 22 stellt die Ausgabe des Stromkreises bereit und ist mit einer externen Last verbunden. Der durch den ersten Transistor 21 fließende Strom wird durch I = (V_{supply}-V_{BE}) / R angegeben. Da die Basis-Emitter-Übergänge beider Transistoren identisch durchlaßvorgespannt sind, muß der gleiche Strom durch beide Transistoren fließen, und der Kollektorstrom des zweiten Transistors 22 stellt daher eine konstante Stromquelle bereit.

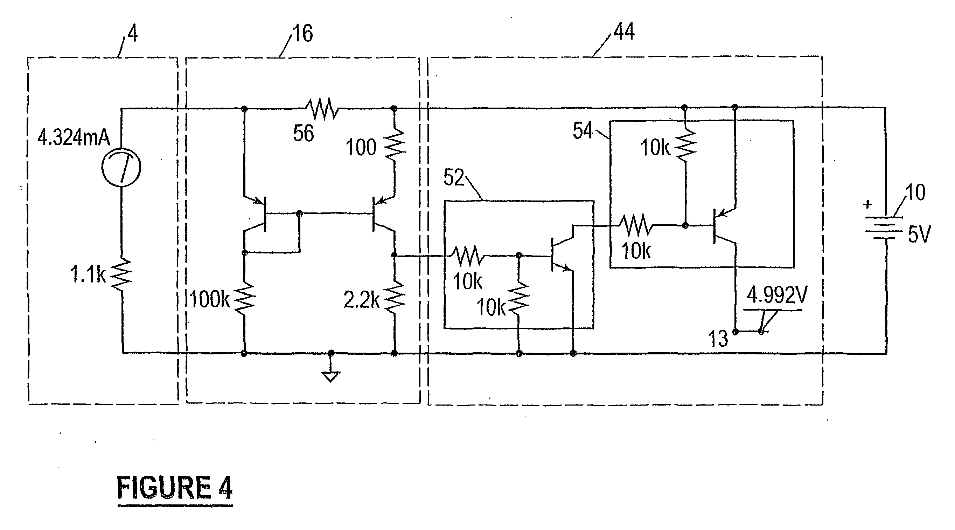

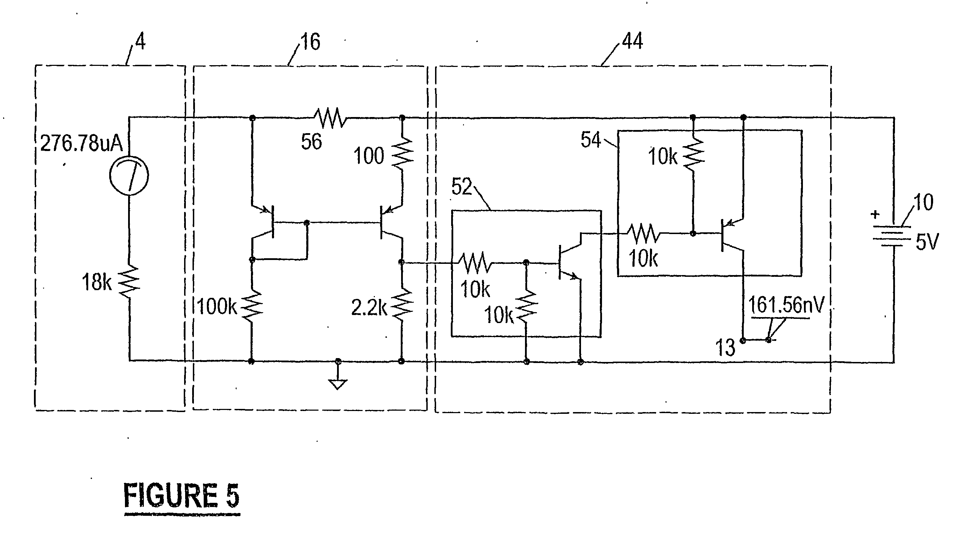

Die stromfühlende Schaltung 16 ist eine modifizierte Spiegelschaltung, wie in Figur 3 gezeigt, die einen stromfühlenden Widerstand 31 in der Versorgungsschiene zwischen den Kollektoren der zwei Transistoren 21 und 22, einen dritten Widerstand 32 zwischen der Versorgungsschiene und dem Kollektor des zweiten Transistors 22, und einen vierten Widerstand 33 zwischen dem Kollektor des zweiten Transistors 22 und Masse aufweist. Das Vorhandensein des stromfühlenden Widerstandes 31 und des dritten Widerstandes 32 erzeugt eine Unsymmetrie in den Emitter-Potentialen der beiden Transistoren, welche von dem von der Last 4 abgenommenen Strom abhängig ist. Der relative Strom, der durch den ersten Transistor 21 und den zweiten Transistor 22 fließt, wird auch durch die relativen Werte des stromfühlenden Widerstands 31 und des dritten Widerstand 32 bestimmt. Die resultierende Ausgangsspannung über den vierten Widerstand 33 steht im gleichen Verhältnis zu dem Laststrom. In dem stromfühlenden Schalterstromkreis 8 wird diese Ausgangsspannung benutzt, um den Vcc Schalterstromkreis 44, wie in Figuren 4 und 5 gezeigt, zu betreiben. Infolgedessen werden die Widerstände gemäß den Schaltkenndaten dieses Stromkreises gewählt. Präziser ausgedrückt, wird der Wert des dritten Widerstandes 32 so gewählt, daß im unbelasteten Zustand (d.h. Bereitschaftsmodus - sleep mode) die Spannung über den vierten Widerstand 33 unter der niedrigeren Schwellspannung liegt, die erforderlich ist, den Vcc Schalterstromkreis 44 zu aktivieren. Der Wert des stromfühlenden Widerstandes 31 wird dann so gewählt, daß unter normaler Belastung, (d.h. Betriebsmodus - run mode) die Ausgangsspannung über den vierten Widerstand 33 größer ist als der obere Schwellspannungspegel, der erforderlich ist, um den Vcc Schalterstromkreis 44 zu aktivieren. Für die Schaltung 2 sind diese Spannungen 200mV bzw. 2V über den vierten Widerstand 33.

Die Figuren 4 und 5 veranschaulichen Ausführungen einer Empfängerschaltung, welche der externen LNA 6 den Strom bereitstellt für die zwei zum Einsatz kommenden Motorola Romeo-2 Demodulatoren 4, die in dem Betriebs- bzw. Bereitschaftsmodus laufen. Es ist denkbar, diese Schaltungen in drei logische Blöcke aufzuteilen: eine Last 4, die stromfühlende Schaltung 16 und den Vcc Schalterstromkreis 44. Wie oben beschrieben, ist die Ausgangsspannung der stromfühlenden Schaltung 16 proportional zu dem von dem Lastblock 4 abgenommenen Strom. Diese Ausgangsspannung wird zum Betrieb des Vcc Schalterstromkreises 44 verwendet, welcher eine geschaltete Ausgabe an der Versorgungsklemme 13 bereitstellt. Präziser ausgedrückt wird die Ausgangsspannung der stromfühlenden Schaltung 54 über einen npn-Transistor-Wechselrichter betrieben. Der Schaltkreis 54 schaltet die Stromzuführung 10 der Versorgungsklemme 13 des externen LNA 6, wenn der Demodulator 4 in Betriebsmodus ist.

In Figur 4 wird der Demodulator 4 mit einer Wirklast von 1,1 kΩ und mit einer Stromabnahme von 4,3 mA in Betriebsmodus gezeigt. Die Ausgabe 13 ist 4,992 V von einer Versorgungsspannung von 5,000 V. In Bereitsschaftsmodus, wie in Figur 5 gezeigt, weist der Demodulator 4 eine Last von 18 kΩ auf und nimmt einen Strom von weniger als 0,3 mA ab. Die entsprechende Ausgangsspannung an der Versorgungsklemme 13 ist geringfügig mit ≈ 152 nV. Daraus geht hervor, daß, wenn der Demodulator 4 von Bereitschaftsmodus auf Betriebsmodus umschaltet, die Ausgangsspannung von ≈ 152 nV auf 4,992V wechselt, was auch als Wechsel von 0,0 auf 5,0V ausgedrückt werden kann. Wenn die Versorgungsklemme 13 benutzt wird, um den externen LNA 6 in Figur 1 einzuschalten, wird der LNA 6 nur unter Strom gesetzt, wenn der Demodulator 4 in Betriebsmodus ist. Der Demodulator 4 und der LNA 6 werden in Tandem eingeschaltet.

Der stromfühlende Schalterstromkreis 8, der vorstehend beschrieben ist, bietet eine Anzahl von Vorteilen gegenüber bekannten Spannungskomparator-Systemen. Der Betriebsstrom eines Schaltelementes ist eine zuverlässigere Anzeige des Arbeitszustands als die Ausgangsspannung, da er weniger empfindlich gegenüber elektrischem Rauschen und Temperaturschwankungen ist. Der erfindungsgemäße stromfühlende Schalterstromkreis ist äußerst stabil über einen großen Temperaturbereich, falls ein angepaßtes Transistor-Paar verwendet wird, welches auf einem einzigen Substrat hergestellt ist. Des weiteren ist der stromfühlende Schalterstromkreis preiswerter als der gleichwertige spannungsfühlende Schalterstromkreis.

Eine Vielzahl von Abwandlungen werden dem Experten gegenwärtig sein, ohne von dem Umfang der vorstehend mit Bezug auf die beiliegenden Zeichnungen beschriebenen Erfindung abzuweichen.

## Patentansprüche

1. Ein stromfühlender Schalterstromkreis (8) mit einer ersten Anschlußklemme (13) für die Stromzuführung (10) für eine erste Einheit (6), wobei gestützt auf den Zustand einer zweiten Einheit (4), der an einer zweiten Anschlußklemme (15) erkannt wird,
die erste Anschlußklemme (13) geschaltet wird, wobei der Zustand durch den Strom erkannt wird, der an der zweiten Anschlußklemme (15) abgenommen wird, **gekennzeichnet durch** einen Schalterstromkreis (44) zum Schalten der ersten Anschlußklemme (13) und eine Stromspiegelanordnung (16) mit spannungsteilenden Widerständen (31, 32), um eine Spannung zu erzeugen, die proportional zu dem Strom an der zweiten Anschlußklemme (15) ist, wobei die Spannung den Schalterstromkreis (44) steuert.

2. Ein stromfühlender Schalterstromkreis (8) gemäß Anspruch 1, worin die zweite Einheit (4) einen Betriebsmodus (run mode) und einen Bereitschaftsmodus (sleep mode) aufweist und, wenn in Betrieb, mit der zweiten Anschlußklemme (15) verbunden ist, und wobei der Strom unterhalb eines Schwellpegels während des Bereitschaftsmodus und oberhalb des Schwellpegels während des Betriebsmodus ist.

3. Ein stromfühlender Schalterstromkreis (8) gemäß Anspruch 1, der folgendes einschließt:
einen ersten Transistor (21) mit einer kurzgeschlossenen Basis und Kollektor und einem ersten Lastwiderstand (23), welcher die erste Abzweigung der Spiegelanordnung (16) bereitstellt; und
einem zweiten Transistor (22) und einem zweiten Lastwiderstand (33), welcher eine zweite Abzweigung der Spiegelanordnung (16) bereitstellt;
worin die spannungsteilenden Widerstände (31, 32) zwischen die Emitter der Transistoren (21, 22) geschaltet sind, mit der Stromzuführung (10) zwischen den spannungsteilenden Widerständen (31, 32);
wobei der Schalterstromkreis (44) mit dem Emitter des ersten Transistors (21) verbunden ist und wobei die zweite Anschlußklemme (15) der Kollektor des zweiten Transistors ist.

4. Ein stromfühlender Schalterstromkreis (8) gemäß Anspruch 3, worin die Transistoren (21, 22) ein angepaßtes Paar auf demselben Substrat hergestellt.

5. Eine Empfängerschaltung (2) für ein Fahrzeug mit einem stromfühlenden Schalterstromkreis (8) gemäß einem beliebigen der Ansprüche 1-4, worin die erste Einheit (6) ein Verstärker ist, und die zweite Einheit (4) ein Hochfrequenz (Rf)-Empfänger ist.

## Claims

1. Current-sensing switching circuit (8) having a first connecting terminal (13) for the current supply (10) for a first unit (6), the first connecting terminal (13) being switched on the basis of the state of a second unit (4), which is detected at a second connecting terminal (15), the state being detected by the current which is drawn at the second connecting terminal (15), **characterized by** a switching circuit (44) for switching the first connecting terminal (13) and a current mirror arrangement (16) having voltage-dividing resistors (31, 32) for generating a voltage that is proportional to the current at the second connecting terminal (15), the voltage controlling the switching circuit (44).

2. Current-sensing switching circuit (8) according to Claim 1, in which the second unit (4) has an operating mode (run mode) and a standby mode (sleep mode) and is connected to the second connecting terminal (15) when in operation, the current being below a threshold level during the standby mode and being above the threshold level during the operating mode.

3. Current-sensing switching circuit (8) according to Claim 1, said circuit including the following:
a first transistor (21) having a short-circuited base and collector and a first load resistor (23) which provides the first branch of the mirror arrangement (16); and
a second transistor (22) and a second load resistor (33) which provides a second branch of the mirror arrangement (16) ;
in which the voltage-dividing resistors (31, 32) are connected between the emitters of the transistors (21, 22), with the current supply (10) between the voltage-dividing resistors (31, 32);
the switching circuit (44) being connected to the emitter of the first transistor (21), and the second connecting terminal (15) being the collector of the second transistor.

4. Current-sensing switching circuit (8) according to Claim 3, in which the transistors (21, 22) are produced as a matched pair on the same substrate.

5. Receiver circuit (2) for a vehicle having a current-sensing switching circuit (8) according to any desired one of Claims 1-4, in which the first unit (6) is an amplifier, and the second unit (4) is a radio-frequency (RF) receiver.

## Revendications

1. Circuit de commutation à détection de courant (8) comprenant une première borne de branchement (13) pour l'alimentation électrique (10) d'une première unité (6), et selon l'état d'une seconde unité (4), reconnu sur une seconde borne (15), on commute la première borne (13),
on détecte l'état par le courant prélevé sur la seconde borne de raccordement (15),
un circuit de courant de commutation (44) pour commuter la première borne de branchement (13) et un dispositif à miroir de courant (16) comprenant des résistances de division de tension (31, 32) pour générer une tension proportionnelle au courant appliqué à la seconde borne de branchement (15), la tension commandant le circuit de commutation de courant (44).

2. Circuit de commutation à détection de courant (8) selon la revendication 1, selon lequel la seconde unité (4) présente un mode de fonctionnement et un mode préparatoire (mode sommeil) et qui en fonctionnement, est relié à la seconde borne de branchement (15) et le courant est inférieur à un seuil en mode préparatoire et au-dessus du seuil en mode de fonctionnement.

3. Circuit de commutation à détection de courant (8) selon la revendication 1, comprenant
- un premier transistor (21) avec une base et un collecteur court-circuité et une première résistance de charge (23) qui assure la première déviation du dispositif de miroir (16) et
- un second transistor (22) et une seconde résistance de charge (33) qui fournit une seconde dérivation du dispositif de miroir (16),
- les résistances de division de tension (31, 32) étant branchées entre les émetteurs des transistors (21, 22), avec l'alimentation électrique (10) entre les résistances de division de tension (31, 32),
- le circuit de commutation (44) étant relié à l'émetteur du premier transistor (21) et
- la seconde borne de branchement (15) est le collecteur du second transistor.

4. Circuit de commutation à détection de courant (8) selon la revendication 3, dans lequel les transistors (21, 22) sont réalisés comme paires adaptées, sur le même substrat.

5. Circuit de réception (2) pour véhicule comportant un circuit de commutation en courant (8) selon l'une quelconque des revendications 1 à 4 dans lequel l'unité (6) est un amplificateur et la troisième unité (4) est un récepteur haute fréquence (Rf).
